# EUROPEAN PATENT APPLICATION

(11) **EP 4 557 360 A1**
(43) Date of publication of application: **21.05.2025**
(21) Application number: 24210814.0
(22) Date of filing: 05.11.2024
(51) Int. Cl.: H01L 23/367, H01L 23/31, H01L 23/495, H01L 23/433, H01L 25/07

(54) **PACKAGED ELECTRONIC DEVICE HAVING HIGH THERMAL DISSIPATION COMPRISING A PLURALITY OF POWER TRANSISTORS**

(30) Priority: 16.11.2023 IT 202300024267
(71) Applicant: STMicroelectronics International N.V., 1228 Plan-les-Ouates, Geneva (CH)
(72) Inventor: STELLA, Cristiano Gianluca, 95027 SAN GREGORIO DI CATANIA (CT) (IT)
(74) Representative: Studio Torta S.p.A.

(57) **Abstract**

Packaged electronic device (50; 70), having a C-shaped leadframe (52) including a base section (52A) and a pair of transverse sections (52B) extending transversely to the base section. A first die (11A, 60) and a second die (11B, 60) have a first contact region (27) at a first main surface and a second contact region (29) at the second main surface; the first main surfaces of the first and the second dice are attached to a first face (58) of the base section (52A) of the leadframe (52). A first lead (53) is coupled to the second contact region (29) of the first die (11A, 60) and has a first external contact portion (53B). A second lead (53) is coupled to the second contact region (29) of the second die and has a second external contact portion (53B). A packaging mass (52) surrounds the leadframe (52), the first lead and the second lead (53), embeds the first and the second dice (11A, 11B, 60) and extends level with the base section (52A) and with the transverse sections (52B) of the leadframe (52) as well as with the external contact portions (53B) of the leads.

## Description

### Technical Field

The present invention relates to a packaged electronic device having high thermal dissipation comprising a plurality of power transistors and to the manufacturing process thereof. In particular, the present invention refers to a high-voltage and/or high-power semiconductor device, comprising vertical MOSFET transistors, for example with a silicon carbide SiC or silicon Si substrate, in drain-to-drain configuration (i.e. with coupling of the drain regions) or planar MOSFET transistors, for example based on gallium nitride GaN, in source-to-source configuration (i.e. with coupling of the source regions), configured for surface mounting and having Dual Side Cooling.

### Background

As known, high-voltage and/or high-current power semiconductor devices are widely used in applications, for example power conversion applications, wherein they are subject to high or very high voltage biasing (with values even up to 1000-2000 V) and are flown by currents that may switch rapidly.

In these devices, particular measures are desired for forming the package, so as to provide a high electrical insulation, a suitable separation distance between the leads associated with the gate, source and drain terminals, and a high heat dissipation to the outside.

Vertical power semiconductor devices (MOSFETs or IGBTs in the case of silicon substrates) are formed in a die of semiconductor material (typically silicon, silicon carbide, silicon and gallium nitride -GaN- or gallium nitride only) which has a first main surface where a drain pad extends, and a second main surface, opposite to the first main surface, where source pads or gate pads extend.

The die is attached to a conductive support called leadframe, provided with drain, source and gate leads for the external connection of the device. To this end, the drain pad is generally attached to a bearing portion of the leadframe, which also has a heat dissipation function; gate and source leads are coupled to the gate and, respectively, source pads by bonding wires or terminals or clips. The assembly die/leadframe is packaged in a mass of resin or other packaging insulating material. The packaging insulating material may be molded or laminated.

Traditional packages for power semiconductor devices are generally arranged vertically and comprise pins protruding downwards from a single bottom side of the packaging structure (generally of parallelepiped shape), for electrical coupling to a Printed Circuit Board (PCB). A suitable heat sinker, typically a metal lamina, is coupled to the packaging structure, also arranged vertically with respect to the printed circuit board.

To obtain increasingly compact dimensions in terms of thickness, horizontal packages have been developed, for example of the Surface Mounting Device (SDM) type, which also allow Dual Side Cooling (DSC).

For example, Italian patent 102018000004782 (corresponding to US patent 10, 910, 302 and EP patent 3561867) describes a double-island package for MOSFET transistors with silicon carbide SiC or silicon Si substrate in source-to-source configuration (i.e. with coupling of the source regions) or for gallium nitride GaN-based MOSFET transistors, in drain-to-drain configuration (i.e. with coupling of the drain regions).

US 2015/348884A1 discloses a power semiconductor package having a multi-section conductive carrier, formed by different parts.

US 2018/102307A1 discloses a semiconductor package for power electronics wherein discrete transistors are electrically connected to form a half-bridge and have the source terminal of one transistor coupled to the drain terminal of the other transistor though a conductive switching element.

The aim of the present invention is to provide a solution that allows obtaining a single double-island package for MOSFET transistors with silicon carbide SiC or silicon Si substrate in drain-to-drain configuration or gallium nitride GaN-based MOSFET transistors, in source-to-source configuration.

### Summary

According to the present invention, a packaged electronic device is provided, as defined in the attached claims.

### Brief Description of the Drawings

For a better understanding of the present invention, some embodiments thereof are now described, purely by way of non-limiting example, with reference to the attached drawings, wherein:
- Figure 1A is a simplified circuit diagram of MOSFET transistors connected using a common-source topology;
- Figure 1B is a simplified circuit diagram of MOSFET transistors connected using a common-drain topology;
- Figure 2A is a simplified circuit diagram of n MOSFET transistors connected in parallel in common-drain topology, through external connections;
- Figure 2B is a simplified circuit diagram of n MOSFET transistors connected in parallel in common-drain topology, through internal connections (islands in the package);
- Figure 3A is a simplified circuit diagram of n MOSFET transistors connected in parallel in common-source topology, through external connections;
- Figure 3B is a simplified circuit diagram of n MOSFET transistors connected in parallel in common-source topology, through internal connections (islands in the package);
- Figure 4 is a simplified cross-section of an example of a MOS transistor usable in the common-drain topology;
- Figure 5 is a top view over a package of two MOSFET transistors mutually coupled using a common-drain topology;
- Figure 6 is a bottom view of the package of Figure 5;
- Figure 7 is a cross-sectional view of the package of Figures 5 and 6;
- Figure 8 is a cross-sectional view of the package of Figure 7, after connection to a support and to a heat sinker;
- Figure 9 is a simplified cross-section of an example of a MOS transistor usable in the common-source topology;
- Figure 10 is a top view over a package of two MOSFET transistors mutually coupled using a common-source topology;
- Figure 11 is a bottom view of the package of Figure 10;
- Figure 12 is a cross-sectional view of the package of Figures 10 and 11; and
- Figure 13 is a cross-sectional view of the package of Figure 12, after connection to a support and a heat sinker.

### Description of Embodiments

The following description refers to the arrangement shown; consequently, expressions such as "above", "below", "upper", "lower", "right", "left" relate to the attached Figures and are not to be interpreted in a limiting manner.

As known, semiconductor switches need to meet two requirements:
- be capable of blocking the voltage in both directions (voltage blocking bidirectionality); and
- allow a current flow in both directions (current bidirectionality) .

MOSFET transistors meet the second requirement, as they are capable of passing the current from the drain terminal to the source terminal and vice versa, but meet the first requirement only partially, since they block the forward voltage from the drain terminal to the source terminal (BV_{DSS}) but the blocking capability in the opposite direction is very small.

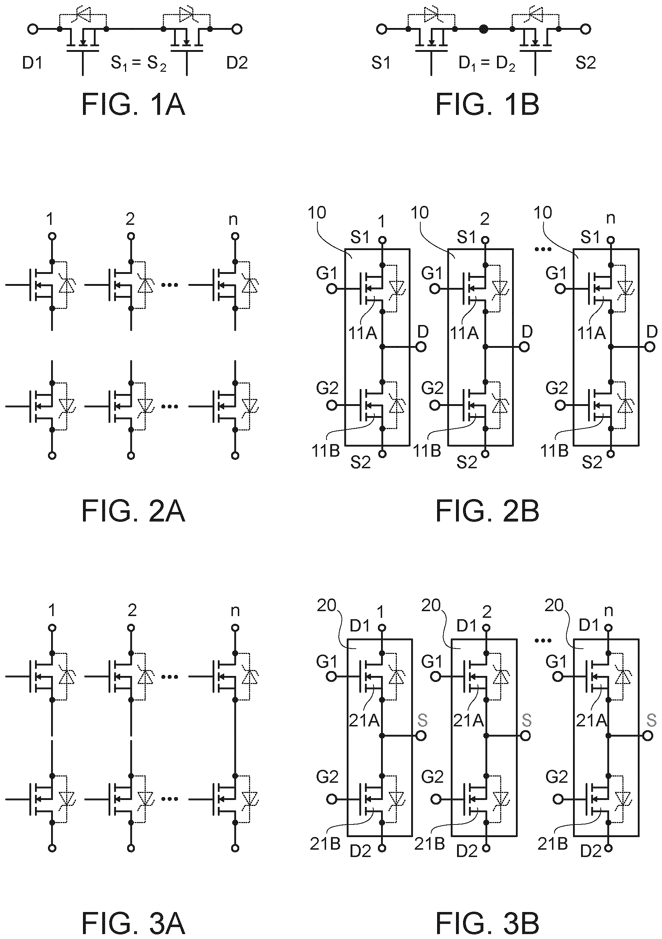

In practice, two topologies are often used for MOSFET transistors: the common-source topology ("back-to-back", shown in Figure 1A) and the common-drain topology (shown in Figure 1B).

The common-source topology is generally preferred, by virtue of the simpler gate driving, but in some applications the common-drain topology is preferred, for example in case of microinverters for solar use using gallium nitride-based transistors or silicon-based devices where reduction of noise and electromagnetic emissions EMI is desired.

For example, such topologies may be used in full-bridge or half-bridge converters wherein the MOSFET transistors have low conduction losses. In the full-bridge configuration, in the on-state, two series-connected drain-source resistors R_{DS(on)} are present, with very low voltage drop.

In particular, as to the common-source topology, the main advantages are:
- no lower limit to conduction losses, since it is sufficient to parallel-connect a suitable number of transistors;
- minimum number of components;
- high-frequency switching capability during charge/discharge phases.

As to the common-drain topology, some limitations may be due to:
- number of dice to be parallel-connected to obtain the desired conduction power loss values;
- the influence of the technology type on the value of the on-state drain-source resistance R_{DS(on)};
- less favorable shape factor;
- charge Qrr linked to the intrinsic body-drain diode which causes, at very high current levels and with a MOSFET transistor in reverse conduction, the current to also be capable of flowing in the antiparallel connected diode.

When n MOSFETs are parallel-connected, as shown in Figure 2A for MOSFET transistors connectable in common-drain topology, the drain-source resistance R_{DS(on)} decreases linearly, to ideally reduce the conduction losses to zero, but the single packages make the layout and parallelization process more complex.

When the n MOSFETs are parallel-connected by double islands in each package, as shown in Figure 2B, the drain-source resistance R_{DS(on)} decreases linearly, to ideally reduce the conduction losses to zero, as in the previous case, but parallelization by the customer is very simple.

In practice, with this coupling, a single electronic device 10 comprises two MOSFET transistors 11A, 11B having a single common-drain terminal D, two source terminals S1, S2 and two gate terminals G1, G2.

Similar considerations apply in the case of common-source topology, shown in Figures 3A and 3B.

In particular, Figure 3B shows a parallel coupling by double islands in each packaged device 20. Here, a single electronic device 20 comprises two MOSFET transistors 21A, 21B having a single common-source terminal S, two drain terminals D1, D2 and two gate terminals G1, G2.

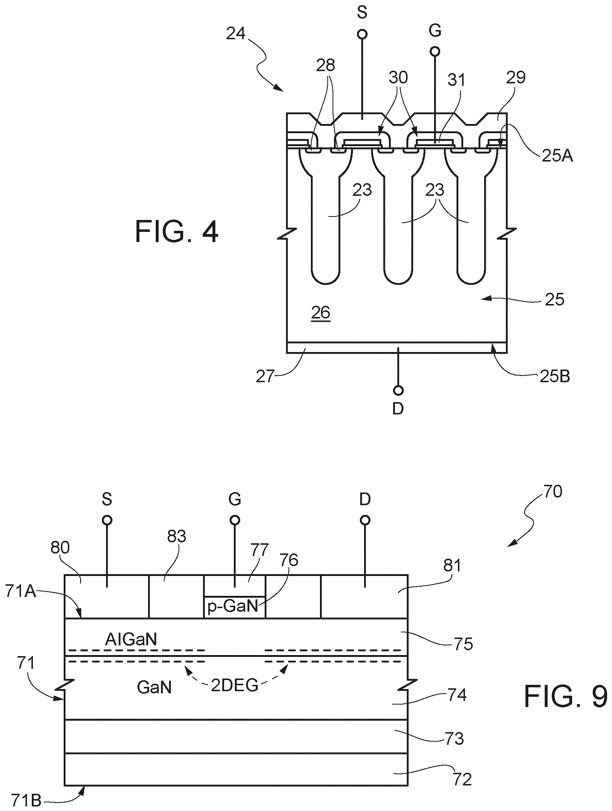

For a greater understanding of the scope of the present disclosure, Figure 4 shows an example of MOSFET transistor 24, with vertical conduction, for example an N-channel MOSFET transistor usable with the common-drain topology, here a charge-balanced transistor (also called a "superjunction" transistor).

In detail, the transistor 24 of Figure 4 comprises a substrate 25 having an upper or first surface 25A and a lower or second surface 25B.

The substrate 25 forms a drain region 26 and is electrically contacted through a drain metal layer 27, extending onto the bottom surface 25B of the substrate 25 and coupled to a drain terminal D.

Source regions 28 are formed in body regions 23 and face the upper surface 25A of the substrate 25. The source regions 28 are contacted by a source metal layer 29 which extends onto the upper surface 25A and is coupled to a source terminal S.

Insulated gate regions 30 extend above the upper surface 25A of the substrate 25 and have respective gate conductive portions 31 coupled to a gate terminal G.

Other implementations are possible, for example in vertical-type silicon carbide technology, which all have the drain metal layer 27 arranged on a first surface (for example the lower surface 25B of the substrate 25), the source metal layer 29 and a gate pad (forming the gate terminal G) arranged on another surface (for example the upper surface 25A of the substrate 25).

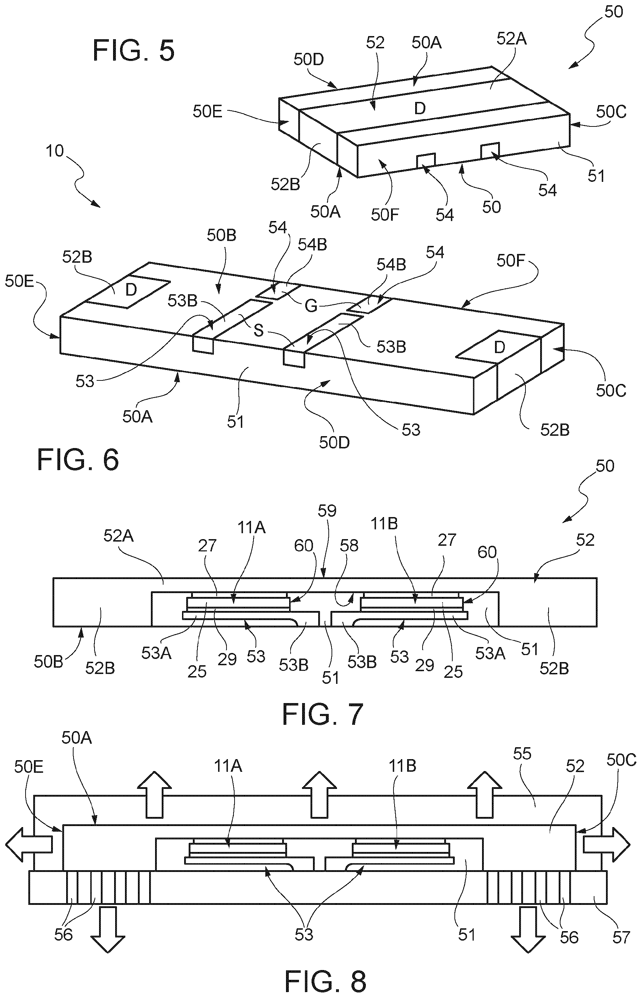

Figures 5-7 show an implementation of the electronic device 10 of Figure 2B, wherein the MOSFET transistors 11A, 11B are for example formed like the MOSFET transistor 24 of Figure 4. For illustrative simplicity, and in a non-limiting manner, hereinafter parts of the MOSFET transistors 11A, 11B are indicated using the reference numerals used for the MOSFET transistor 24 of Figure 4.

In particular, Figures 5-7 show a packaged device 50, of surface mounting type, comprising the two MOSFET transistors 11A, 11B, of which, in Figure 7, only the substrates 25, the drain metal layers 27 and the source metal layers 29 are represented.

The structure formed by each substrate 25, the respective drain metal layer 27, the respective source metal layer 29 and the respective gate metallization (not shown) is a die 60.

The packaged device 50 is embedded in a packaging mass 51, of resin or other insulating material, which completely surrounds the MOSFET transistors 11A, 11B, except for the external terminals of the packaged device 50, which extend level with the packaging mass 51, as detailed below.

Overall, the packaged device 50 has a parallelepiped shape formed by two main surfaces 50A, 50B, having rectangular shape, mutually opposite (first and second main surfaces 50A, 50B), and four lateral surfaces 50C-50F (first, second, third and fourth lateral surfaces 50C, 50D, 50E and 50F) .

Two lateral surfaces (first and third lateral surfaces 50C, 50E) correspond to the short sides of the rectangular shapes of the main surfaces 50A, 50B and two lateral surfaces (second and fourth lateral surfaces 50D, 50F) correspond to the long sides of the rectangular shapes of the main surfaces 50A, 50B.

The packaged device 50 comprises a support structure (hereinafter also referred to as leadframe) 52, of metal, which is the drain terminal D of Figure 2B; two source leads 53, of metal, which are the source terminals S1 and S2 of Figure 2B; and two gate leads 54, of metal, which are the gate terminals G1, G2 of Figure 2B.

The leadframe 52 has the shape of a C, with a base side 52A (Figure 5) and two transverse sides 52B.

The base side 52A of the leadframe 52 has an internal face 58, facing the inside of the packaged device 50, and an external face 59, level with the first main surface 50A of the packaged device 50.

As visible in Figure 7, the base side 52A of the leadframe 52, on its internal face 58, is in direct contact with the drain metal layers 27 of the MOSFET transistors 11A, 11B, electrically coupling them. It therefore forms a double, unique and common island for connecting the drain regions (26 in Figure 4) of the MOSFET transistors 11A, 11B.

The transverse sides 52B of the leadframe 52 extend from the base side 52A, level with the first and the third lateral surfaces 50C, 50E, up to the second main surface 50B, at a distance from the MOSFET transistors 11A, 11B.

The source leads 53 have, in lateral view, the shape of an inverted L, and each comprise a source base plate 53A, in electrical contact with a respective source metal layer 29 (Figure 4), and a respective source foot 53B, monolithic with the respective source base plate 53A. Each source foot 53B extends between the respective source base plate 53A and the second main surface 50B, level with the latter.

Furthermore, each source foot 53B has a lateral end portion extending level with the second lateral surface 50D (Figure 6).

The gate leads 54 have a similar shape to the source leads 53, inverted L-shaped in lateral view, and each comprise a gate plate (not visible) and a gate foot 54B.

The gate plates (not visible) of the gate leads 54 are in electrical contact with the gate pads (not shown) which form the gate terminals G of Figure 2B and are arranged on the same side of the MOSFET transistor 24, laterally to the source metal layer 29.

The gate feet 54B, having for example the same shape as (or similar shape to) the source feet 53B, protrude level with the second main surface 50B of the packaged device 50, alongside, but spaced from the source feet 53B, as visible in Figure 6.

Furthermore, each gate foot 54B has a lateral end portion extending level with the fourth lateral surface 50F (Figure 5).

In this manner, the packaged device 50 implements, in a simple and efficient manner, the surface mounting drain-to-drain configuration.

The packaged device 50 has a wide dissipation surface, since the dissipation may occur on both main surfaces 50A, 50B, and therefore may be used in high-power applications.

The dissipative capability of the packaged device 50 may be increased in the manner shown in Figure 8, by arranging a heat sinker 55, C-shaped, in contact with the first main surface 50A of the packaged device 50 and with at least the first and the third lateral surfaces 50C, 50E.

Furthermore, the packaged device 50 is capable of dissipating heat also at its second main surface 50B.

In particular, a high thermal flow is obtained by forming thermal vias 56 (for example metal through regions) in a support 57 having the same packaged device 50 (for example a printed circuit board) attached thereto, as shown in Figure 8.

Figure 9 shows an example of a MOSFET transistor 70 usable with the common-source topology, here a planar power MOSFET transistor made by using the gallium nitride (GaN) based technology.

In detail, the MOSFET transistor 70 comprises a semiconductor body 71, having an upper surface 71A and a lower surface 71B.

The semiconductor body 71 here comprises a substrate 72, for example of silicon, defining the lower surface 71B; a buffer layer 73, of gallium nitride (GaN), superimposed on the substrate 72; a channel layer 74, for example of gallium nitride (GaN), superimposed on the buffer layer 73; and a barrier layer 75, for example of aluminum gallium nitride (AlGaN), superimposed on the channel layer 74 and defining the upper surface 71A of the semiconductor body 71.

A gate region 76, of conductive material, for example of gallium nitride, with P-type conductivity (p-GaN), extends above the barrier layer 75; a gate contact region 77, of metal, for example of TiN/AlCu/TiN, extends above and in direct electrical contact with the gate region 76; a source contact region 80, of metal, for example of Ti/AlCu/TiN, extends above and in direct electrical contact with the barrier layer 75, on a first side of the gate region 76; a drain contact region 81, of metal, for example of Ti/AlCu/TiN, extends above and in direct electrical contact with the barrier layer 75, on a second side, opposite to the first side, of the gate region 76; and an insulating layer 83, for example of silicon oxide, extends above the upper surface 71A of the semiconductor body 71, between the gate region 76, the gate contact region 77, the source contact region 80 and the drain contact region 81.

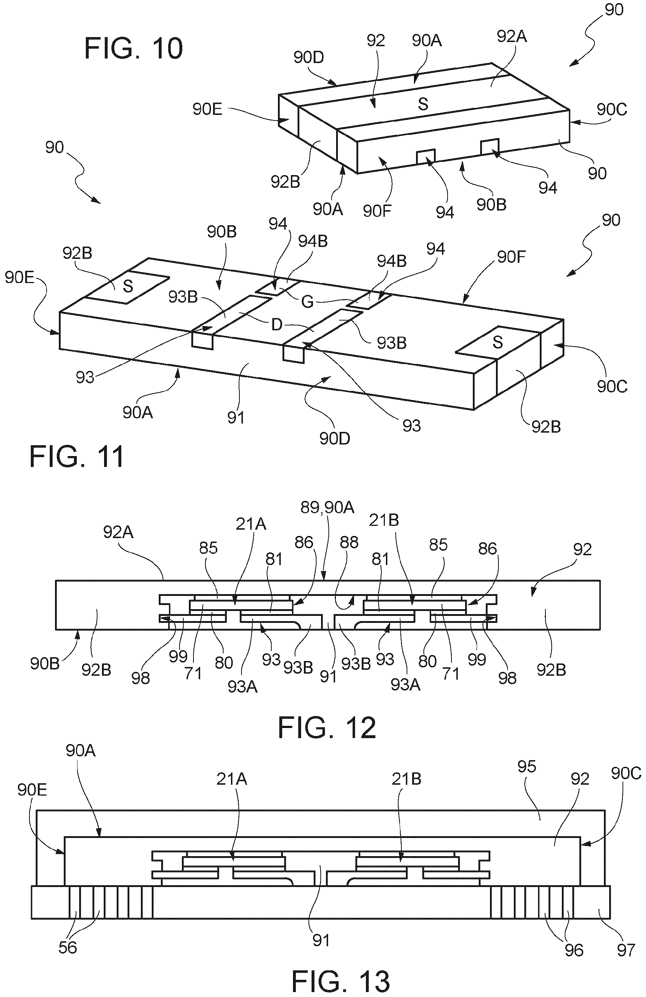

Figures 10-12 show an implementation of the packaged device 20 of Figure 3B, wherein the MOSFET transistors 21A, 21B are for example formed like the MOSFET transistor 70 of Figure 9. For illustrative simplicity, and in a non-limiting manner, hereinafter parts of the MOSFET transistors 21A, 21B are indicated using the reference numerals used for the MOSFET transistor 70 of Figure 9.

In particular, Figure 12 shows a packaged device 90, of surface mounting type, comprising the two MOSFET transistors 21A, 21B, of which only the semiconductor bodies 71, the source contact region 80, the drain contact region 81 and a rear metallization 85 in contact with the lower surface 71B of the semiconductor body 71 are represented.

The structure formed by each semiconductor body 71, the respective source contact region 80, the respective drain contact region 81 and the respective rear metallization 85 forms a die 86.

The packaged device 90 is embedded in a packaging mass 91, of resin or other insulating material, which completely surrounds the MOSFET transistors 21A, 21B, except for the external terminals of the packaged device 90, which extend level with the packaging mass 91, as detailed below.

Overall, the packaged device 90 has a parallelepiped shape formed by two, mutually opposite, main surfaces 90A, 90B, having rectangular shape (first and second main surfaces 90A, 90B), and four lateral surfaces 90C-90F (first, second, third and fourth lateral surfaces 90C, 90D, 90E and 90F).

Two lateral surfaces (first and third lateral surfaces 90C, 90E) correspond to the short sides of the rectangular shapes of the main surfaces 90A, 90B and two lateral surfaces (second and fourth lateral surfaces 90D, 90F) correspond to the long sides of the rectangular shapes of the main surfaces 90A, 90B.

The packaged device 90 comprises a support structure (hereinafter also referred to as leadframe) 92, of metal, which is the source terminal S of Figure 3B; two drain leads 93, of metal, which are the drain terminals D1 and D2 of Figure 3B; and two gate leads 94, of metal, which are the gate terminals G1, G2 of Figure 3B.

The leadframe 92 has the shape of a C, with a base side 92A and two transverse sides 92B.

The base side 92A of the leadframe 92 has an internal face 88, facing the inside of the packaged device 90, and an external face 89, level with the first main surface 90A of the packaged device 90.

As visible in Figure 12, the base side 92A of the leadframe 92, on its internal face 88, is in direct contact with the rear metallizations 85 of the MOSFET transistors 21A, 21B, electrically coupling them.

The transverse sides 92B of the leadframe 92 extend from the base side 92A, level with the first and the third lateral surfaces 90C, 90E, up to the second main surface 90B, at a distance from the MOSFET transistors 21A, 21B.

The transverse sides 92B of the leadframe 92 extend up to the second main surface 90B of the packaged device 90 and have respective recesses 98 facing the inside of the packaged device 90.

The drain leads 93 have, in lateral view, the shape of an inverted L, and each comprise a drain base plate 93A, in electrical contact with a respective drain contact region 81 (Figure 9), and a respective drain foot 93B, monolithic with the respective drain base plate 93A. Each drain foot 93B extends between the respective drain base plate 93A and the second main surface 90B, level therewith.

Furthermore, each drain foot 93B has a lateral end portion extending level with the second lateral surface 90D (Figure 11).

The gate leads 94 have a shape similar to the drain leads 93 and each comprises a gate plate (not visible) and a gate foot 94B (Figure 11).

The gate plates (not visible) of the gate leads 94 are in electrical contact with the gate contact regions 77 of Figure 9 and are arranged on the same side of the MOSFET transistor 70, lateral to the drain contact regions 81 of Figure 9.

The gate feet 94B, having for example the same shape as (or a similar shape to) the source feet 93B, protrude level with the second main surface 90B of the packaged device 90, alongside, but spaced from the drain feet 93B, as visible in Figure 11.

Furthermore, each gate foot 94B has a lateral end portion extending level with the fourth lateral surface 90F (Figure 10).

The connection structures of the dice 86 also comprise a pair of source plates 99.

Each source plate 99 is in electrical contact (for example, in direct contact) with a respective source contact region 80 (Figure 9), protrudes laterally with respect to the respective die 86 and extends, with its protruding end, into a respective recess 98 of the transverse sides 92B of the leadframe 92. The source plates 99 are blocked, for example fit or welded/soldered, in the respective recesses 98.

In this manner, the leadframe 92 and the source plates 99 create a direct electrical connection between the source contact regions 80 of the MOSFET transistors 21A, 21B and the substrates 72, as well as between the substrates 72. The base side 92A of the leadframe 92 is therefore the source terminal S of the packaged device 20 of Figure 3B and therefore represents a double, unique and common island for connecting the source contact regions 80 (Figure 9) of the MOSFET transistors 21A, 21B.

In this manner, the packaged device 90 forms, in a simple and efficient manner, the surface mounting source-to-source configuration.

The packaged device 90 of Figures 10-12 also has a high dissipation surface, and the dissipative capability may be increased in the manner shown in Figure 13, by arranging an C-shaped heat sinker 95 in contact with the first main surface 90A of the packaged device 90 and with at least the first and the third lateral surfaces 90C, 90E.

Furthermore, the packaged device 90 of Figures 10-12 is capable of dissipating heat also at its second main surface 90B.

In particular, a high thermal flow is obtained by forming thermal vias 96 (for example metal through regions) in a support 97 having the same packaged device 90 (for example a printed circuit board) attached thereto, as shown in Figure 13.

Finally, it is clear that modifications and variations may be made to the packaged electronic device described and illustrated herein without thereby departing from the scope of the present invention, as defined in the attached claims.

## Claims

1. A packaged electronic device (50; 70), including vertical MOSFET transistors in drain-to-drain configuration or planar MOSFET transistors in source-to-source configuration, comprising:
a leadframe (52; 92) C-shaped, including a base section (52A; 92A) and a pair of transverse sections (52B; 92B), the base section (52A; 92A) having a first and a second face (58, 59; 88, 89) and the transverse sections (52B; 92B) extending transversely to the base section;
a first die (11A, 60; 21A, 86) and a second die (11B, 60; 21B, 86), the first and the second dice each having a first main surface and a second main surface, a first contact region (27; 85) at the first main surface of the first and the second dice (11A, 11B, 60; 21A, 21B, 86), a second contact region (29; 81) at the second main surface of the first and the second dice, the first main surface of the first and the second dice being attached to the first face (58; 88) of the base section (52A; 92A);
a first lead (53; 93), coupled to the second contact region (29; 81) of the first die (11A, 60; 21A, 86) and having a first external contact portion (53B; 93B);
a second lead (53; 93) coupled to the second contact region (29; 81) of the second die and having a second external contact portion (53B; 93B);
a packaging mass (52; 92) surrounding the leadframe (52; 92), the first and the second leads (53; 93) and embedding the first and the second dice (11A, 11B, 60; 21A, 21B, 86),
wherein the packaging mass (52; 92) extends level with the base section (52A; 92A) and with the transverse sections (52B; 92B) of the leadframe (52; 92) as well as with the first and the second external contact portions (53B; 93B) of the first and, respectively, the second lead (53; 93).

2. The device according to claim 1, wherein the second lead (53; 93) is spaced from the first lead (53; 93).

3. The device according to claim 1 or 2, wherein the first die (11A, 60; 21A, 86) is spaced from the second die.

4. The device according to any of the preceding claims, wherein:
the packaging mass (52; 92) forms a first and a second main surface (50A, 50B; 90A, 90B), opposite to each other, and a first, a second, a third and a fourth lateral surface (50C-50F; 90C-90F), the first and the third lateral surfaces (50C, 50E; 90C, 90E) being mutually opposite and the second and the fourth lateral surfaces (50D, 50F; 90D, 90F) being mutually opposite,
the second face (59; 89) of the leadframe (52; 92) is level with the first main surface (50A; 90A) of the packaging mass (52; 92),
the transverse sections (52B; 92B) are level with the first and, respectively, the third lateral surface (50C, 50E; 90C, 90E) of the packaging mass,
the first and the second external contact portions (53B; 93B) of the first and, respectively, the second lead (53; 93) are level with the second main surface (50B; 90B) of the packaging mass.

5. The device according to the preceding claim, wherein the first and the second external contact portions (53B; 93B) of the first and, respectively, the second lead (53; 93) are also level with the second and, respectively, the fourth lateral surface (50D, 50F; 90D, 90F) of the packaging mass (52; 92).

6. The device according to claim 4 or 5, wherein the first and the second dice (11A, 11B, 60; 21A, 21B, 86) each comprise a respective third contact region (G; 77) arranged on the second main surface of the first and, respectively, the second die, the device further comprising a third and a fourth lead (54; 84), the third lead (54) coupled to the third contact region (G; 77) of the first die (11A, 60) and having a third external contact portion (54B; 84B) level with the packaging mass (52; 92), and the fourth lead (54; 84) coupled to the third contact region (G; 77) of the second die (11B, 60; 21B, 86) and having a fourth external contact portion (54B; 84B) level with the packaging mass.

7. The device according to the preceding claim, wherein the first and the second dice (11A, 11B, 60; 21A, 21B, 86) are vertical MOSFET devices, the first contact region (27) of the first and the second dice being drain contact regions, the second contact region (29) of the first and the second dice being source contact regions, the third contact region (G) of the first and the second dice being gate contact regions.

8. The device according to the preceding claim, wherein the first and the second dice (11A, 11B, 60) are silicon- or silicon carbide-based MOSFET devices.

9. The device according to claim 6, wherein the first and the second dice (21A, 21B, 84) are planar MOSFET devices having respective source contact regions (80) extending at the second face of the first and the second dice, the first contact region (72) of the first and the second dice being a substrate contact region, the second contact region (81) of the first and the second dice being a drain contact region, the third contact region (77) of the first and the second dice being a gate contact region, the device further comprising source contact plate (99), coupled to the source contact regions (80) and in electrical contact with the transverse sections (52B; 92B) of the leadframe (52; 92).

10. The device according to the preceding claim, wherein the transverse sections (52B; 92B) of the leadframe (52; 92) have recesses (98) facing the first and the second dice and coupled to respective edges of the source contact plates (99) .

11. The device according to claim 9 or 10, wherein the first and the second dice are gallium nitride-based MOSFET devices.

12. The device according to any of the preceding claims, wherein the packaging mass (52; 92) comprises a first main surface (50A; 90A) level with the second face (59; 89) of the leadframe (52; 92) and a second main surface (50B; 90B) level with the first and the second external contact portions (53B; 93B), the device further comprising a heat sinker (55; 95) which is C-shaped and is in contact with the second face (59; 89) of the leadframe (52; 92).

13. The device according to the preceding claim, further comprising a support (57; 97) provided with thermal vias (56; 96), in contact with the packaging mass.
